# FASCICULE DE BREVET EUROPEEN

(11) **EP 3 806 167 B1**
(45) Date de publication et mention de la délivrance du brevet: **12.01.2022**
(21) Numéro de dépôt: 20200181.4
(22) Date de dépôt: 06.10.2020
(51) Int. Cl.: H01L 31/107, H01L 31/109

(54) **PROCEDE DE FABRICATION D'AU MOINS UNE PHOTODIODE PLANAIRE CONTRAINTE EN TENSION**
VERFAHREN ZUR HERSTELLUNG MINDESTENS EINER PLANAREN FOTODIODE UNTER SPANNUNG
METHOD FOR MANUFACTURING AT LEAST ONE PLANAR PHOTODIODE STRESSED BY TENSIONING

(30) Priorité: 08.10.2019 FR 1911123
(43) Date de publication de la demande: 14.04.2021
(73) Titulaire: Commissariat à l'Energie Atomique et aux Energies Alternatives, 75015 Paris (FR)
(72) Inventeur: ALIANE, Abdelkader, 38054 GRENOBLE cedex 09 (FR); OUVRIER-BUFFET, Jean-Louis, 38054 GRENOBLE cedex 09 (FR)
(74) Mandataire: INNOV-GROUP

(56) Documents cités:
- WO-A1-2018/050996
- FR-A1- 2 979 037
- US-A1- 2005 040 411
- US-A1- 2013 202 005

## Description

### DOMAINE TECHNIQUE

Le domaine de l'invention est celui des dispositifs optoélectroniques comportant au moins une photodiode planaire réalisée à base d'un composé semiconducteur contraint en tension, par exemple à base de germanium. L'invention trouve une application notamment dans le domaine de la détection d'un rayonnement lumineux appartenant par exemple au proche infrarouge, par exemple dans le domaine des télécommunications optiques et de l'imagerie infrarouge.

### ÉTAT DE LA TECHNIQUE ANTÉRIEURE

Dans diverses applications microélectroniques ou optoélectroniques, il peut être avantageux d'utiliser une couche en un composé semiconducteur cristallin, de préférence monocristallin, présentant une contrainte mécanique en tension. C'est le cas notamment de certains dispositifs optiques dont le matériau de la couche optiquement active présente, hors contrainte, une structure de bandes d'énergie indirecte, la structure de bandes étant alors rendue directe par l'application d'une contrainte en tension suffisante. Le composé semiconducteur cristallin peut être un composé à base de germanium, par exemple du germanium, du germanium étain, voire du silicium germanium.

Ainsi, le document US2014/0291682 décrit une photodiode à avalanche dont la couche semiconductrice d'absorption est réalisée en germanium contraint en tension. La photodiode est alors adaptée à absorber un rayonnement lumineux jusqu'à une longueur d'onde de coupure supérieure à 1550nm, qui est la longueur d'onde de coupure d'absorption du germanium relaxé. Pour cela, la couche de germanium est revêtue par une couche de mise en contrainte formée d'un empilement de sous-couches de nitrure de silicium, d'oxyde de silicium et de silicium amorphe. Cependant, cette photodiode présente notamment l'inconvénient d'être obtenue en ayant recours à des techniques d'ingénierie de la contrainte mécanique par dépôt d'un empilement de couches minces, ce qui peut rendre complexe le procédé de fabrication.

Le document EP3151265 décrit un dispositif optoélectronique à diode comportant une couche semiconductrice contrainte en tension et réalisée à base de germanium. La couche semiconductrice a été ici mise en tension par une structuration localisée préalable de la couche, puis par une mise en suspension de la couche structurée au-dessus d'un substrat, suivi d'une solidarisation à ce dernier par collage direct. Un recuit de consolidation est enfin mis en oeuvre pour améliorer la tenue mécanique de la couche structurée contrainte collée au substrat. Cependant, ce dispositif optoélectronique présente notamment l'inconvénient d'être obtenu par un procédé de fabrication relativement complexe. De plus, comme dans le document précédent, la maîtrise de la valeur de la contrainte en tension effectivement subie par la couche semiconductrice peut être particulièrement difficile.

### EXPOSÉ DE L'INVENTION

L'invention a pour objectif de remédier au moins en partie aux inconvénients de l'art antérieur, et plus particulièrement de proposer un procédé de fabrication d'au moins une photodiode planaire qui permet de générer une contrainte mécanique en tension dans la photodiode de manière simple et précise.

Pour cela, l'objet de l'invention est un procédé de fabrication d'au moins une photodiode planaire, comportant les étapes suivantes :
- réalisation d'un empilement formé : d'au moins une couche semiconductrice réalisée à base d'un premier matériau semiconducteur cristallin ; et d'une couche antireflet, s'étendant au contact d'une première face de la couche semiconductrice, et formée de plusieurs sous-couches parallèles entre elles, dont une sous-couche dite de germination réalisée à base d'un deuxième matériau semiconducteur cristallin présentant un coefficient de dilatation thermique inférieur à celui du premier matériau semiconducteur cristallin ;
- réalisation d'au moins une tranchée périphérique, s'étendant au travers de la couche semiconductrice à partir d'une deuxième face de celle-ci opposée à la première face et débouchant sur la sous-couche de germination, délimitant une portion dite de détection de la couche semiconductrice ;
- réalisation d'une portion périphérique, réalisée en le deuxième matériau semiconducteur cristallin, par épitaxie à partir de la sous-couche de germination à une température dite d'épitaxie supérieure à la température ambiante, et remplissant entièrement la tranchée périphérique et étant ainsi au contact de la portion de détection ;
- diminution de la température à une valeur inférieure à la température d'épitaxie, la portion de détection étant alors contrainte en tension par la portion périphérique.

Certains aspects préférés mais non limitatifs de ce procédé de fabrication sont les suivants.

Le procédé de fabrication peut comporter les étapes suivantes :
- réalisation d'un premier substrat comportant une première couche semiconductrice en le premier matériau semiconducteur cristallin, revêtue d'une première couche diélectrique de collage ;
- réalisation d'un deuxième substrat comportant une couche en le deuxième matériau semiconducteur cristallin destinée à former la sous-couche de germination, revêtue d'une deuxième couche diélectrique de collage, et assemblée à une couche support par une couche isolante ;
- assemblage des deux substrats l'un à l'autre, par collage moléculaire des première et deuxième couches diélectriques de collage, et ainsi obtention de la couche antireflet, les première et deuxième couches diélectriques de collage formant une première sous-couche de la couche antireflet et la couche isolante formant une troisième sous-couche de la couche antireflet.

La couche antireflet peut comporter une première sous-couche formée par les première et deuxième couches diélectriques de collage, la sous-couche de germination du deuxième substrat, et une troisième sous-couche formée par la couche isolante du deuxième substrat.

La portion de détection peut être réalisée à base de germanium, et la portion périphérique ainsi que la sous-couche de germination peuvent être réalisées à base de silicium.

La température d'épitaxie peut être comprise entre 500°C et 700°C.

Plusieurs photodiodes planaires peuvent être réalisées, la sous-couche de germination s'étendant continûment en regard de chaque photodiode, les portions périphériques étant réalisées par épitaxie à partir de la sous-couche de germination.

L'invention a également pour objectif de proposer un dispositif optoélectronique comportant au moins une photodiode planaire et de préférence une matrice de photodiodes planaires, présentant un encombrement réduit et dans le cas de la matrice de photodiodes une haute résolution spatiale, et susceptibles d'être obtenues par un procédé de fabrication simplifié.

Le dispositif optoélectronique peut comporter au moins une photodiode planaire, ladite photodiode comportant :
- une portion de détection, présentant une première face et une deuxième face parallèles entre elles, réalisée en un premier matériau semiconducteur cristallin, et contrainte en tension dans un plan parallèle auxdites faces ;
- une couche antireflet s'étendant sur et au contact de la première face de la portion de détection, formée de plusieurs sous-couches parallèles entre elles, dont une sous-couche dite de germination réalisée à base d'un deuxième matériau semiconducteur cristallin présentant un coefficient de dilatation thermique inférieur à celui du premier matériau semiconducteur cristallin ;
- une portion périphérique, réalisée en le deuxième matériau semiconducteur cristallin, s'étendant autour et au contact de la portion de détection, et au contact avec relation d'épitaxie avec la sous-couche de germination.

La portion périphérique peut être en saillie vis-à-vis de la première face et vis-à-vis de la deuxième face.

La portion de détection peut comporter une première région dopée selon un premier type de conductivité et affleurant la deuxième face, et une deuxième région dopée selon un deuxième type de conductivité opposé au premier type et affleurant la première face et étant au contact de la portion périphérique, la portion périphérique étant dopée selon le deuxième type de conductivité.

La portion de détection peut comporter une région intermédiaire intrinsèque ou dopée selon le deuxième type de conductivité, séparant la première région vis-à-vis de la deuxième région.

La portion périphérique peut entourer la portion de détection continûment.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
la figure 1A est une vue schématique et partielle, en coupe transversale, d'une photodiode planaire selon un mode de réalisation ;
les figures 1B et 1C sont des vues de dessus, schématiques et partielles, d'une photodiode planaire selon des variantes du mode de réalisation illustré sur la fig. 1A ;
les figures 2A à 2K illustrent, de manière schématique et partielle, différentes étapes d'un procédé de fabrication d'au moins une photodiode planaire identique ou similaire à celle illustrée sur la fig.1A ;
les figures 3A et 3B sont des vues de dessus, schématiques et partielles, d'une photodiode planaire selon d'autres variantes du mode de réalisation illustré sur la fig. 1A.

### EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

L'invention porte notamment sur un procédé de fabrication d'au moins une photodiode planaire, et de préférence d'une matrice de photodiodes planaires. Chaque photodiode est de préférence adaptée à détecter un rayonnement lumineux dans le proche infrarouge (SWIR, pour *Short Wavelength IR,* en anglais) correspondant à la gamme spectrale allant de 0.8µm à 1.7µm environ, voire à 2.5µm environ, et est de préférence réalisée à base de germanium.

Les photodiodes sont dites planaires dans la mesure où elles s'étendent suivant un même plan principal, entre des première et deuxième faces parallèles et opposées l'une à l'autre. Elles comportent chacune une portion semiconductrice dite de détection, au sein de laquelle est présente une jonction PN ou PIN, présentant une épaisseur sensiblement constante entre les première et deuxième faces. Chaque photodiode comporte une première région dopée selon un premier type de conductivité, par exemple de type n+, affleurant l'une des faces et formant un caisson dopé n+, une deuxième région dopée selon un deuxième type de conductivité, par exemple de type p+, affleurant la face opposée, et une région intermédiaire située entre les deux régions dopées et entourant la première région dopée n+ dans le plan principal. Cette région intermédiaire peut être dopée selon le deuxième type de conductivité, par exemple de type p, pour former une jonction PN, ou être intrinsèque, c'est-à-dire non intentionnellement dopée, pour former une jonction PIN. Les photodiodes planaires ne présentent alors pas une structure en mesa, et sont isolées optiquement les unes des autres par des tranchées périphériques remplies par un matériau semiconducteur cristallin dopé selon le deuxième type de conductivité, formant des portions semiconductrices dites périphériques.

La portion de détection de la photodiode planaire est entourée, dans un plan principal de la photodiode, par une portion périphérique. Comme décrit en détail plus loin, la portion périphérique assure, lors du procédé de fabrication, la mise en tension de la portion de détection suivant le plan principal, du fait d'une réalisation du matériau semiconducteur dopé remplissant la tranchée périphérique à une température d'épitaxie supérieure à la température ambiante, ce matériau semiconducteur dopé présentant un coefficient de dilatation thermique inférieur à celui associé à la portion de détection. Par ailleurs, le matériau semiconducteur dopé est un matériau cristallin réalisé par épitaxie à partir d'une sous-couche de germination appartenant à une couche antireflet qui s'étend en regard de la portion de détection. La portion périphérique, par le fait qu'elle est liée par épitaxie à la sous-couche de germination, permet de maintenir la portion de détection contrainte en tension.

Aussi, la photodiode selon l'invention comporte une portion de détection du rayonnement lumineux à détecter présentant une contrainte en tension suivant le plan principal, une portion périphérique assurant l'isolation optique des photodiodes, la polarisation de la photodiode, et la mise en contrainte de la portion de détection, et une couche antireflet permettant de réduire la réflexion du rayonnement lumineux d'intérêt à la surface de la photodiode, et assurant le maintien de la contrainte en tension dans la portion de détection par la liaison épitaxiale entre la portion périphérique et la sous-couche de germination.

Les contraintes en tension subies par la portion de détection se traduisent alors par une modification des propriétés optiques et/ou électriques de la photodiode, comme, par exemple, un élargissement de la gamme spectrale d'absorption d'un rayonnement lumineux. La mise en contrainte en tension peut également être suffisante pour rendre sensiblement directe la structure de bandes d'énergie du composé semiconducteur de la portion de détection (par ex. du germanium), dans le cas où ce dernier présente une structure de bandes indirecte lorsqu'il est à l'état relaxé.

D'une manière générale, par portion contrainte, on entend une portion réalisée en un composé semiconducteur cristallin subissant une contrainte mécanique en tension ou en compression, entraînant une déformation des mailles de son réseau cristallin. La portion est contrainte en tension lorsqu'elle subit une contrainte mécanique qui tend à étirer les mailles du réseau dans un plan. Dans le cadre de l'invention, la portion de détection est contrainte en tension dans un plan principal de la photodiode parallèle auxdites première et deuxième faces. Cela se traduit par le fait que son paramètre de maille, dans le plan principal, présente une valeur dite effective supérieure à sa valeur naturelle lorsque le composé semiconducteur est relaxé (i.e. non contraint). Dans la suite de la description, sauf indication contraire, la contrainte considérée est orientée dans le plan principal de la photodiode.

Le matériau semiconducteur cristallin de la portion de détection, alors soumis à des contraintes mécaniques en tension, présente donc des propriétés optiques et/ou électriques modifiées. En particulier, il peut présenter une énergie de bande interdite diminuée, notamment celle associée à la vallée Γ (ou vallée directe). L'énergie de bande interdite peut être estimée en fonction de la déformation en tension, comme le décrit dans le cas d'une couche en germanium la publication de Guilloy et al. intitulée Germanium under high tensile stress: Nonlinear dependence of direct band gap us strain, ACS Photonics 2016, 3, 1907-1911. Par ailleurs, la contrainte mécanique en tension subie par la portion de détection peut être suffisante pour que la structure de bandes d'énergie devienne directe.

Par structure de bandes directe, on entend que le minimum d'énergie E_{BC,L} de la bande de conduction de la vallée L (ou vallée indirecte) est supérieur ou sensiblement égal au minimum d'énergie E_{BC,Γ} de la bande de conduction de la vallée Γ (ou vallée directe), autrement dit : ΔE = E_{BC,L} - E_{BC,Γ} ≥ 0. Par sensiblement égal, on entend ici que cette différence d'énergie est de l'ordre de grandeur ou inférieure à kT, où k est la constante de Boltzmann et T la température du matériau. De préférence, la portion semiconductrice de détection est réalisée à base de germanium dont la structure de bandes d'énergie est indirecte à l'état relaxé, autrement dit ΔE < 0, et devient directe lorsqu'elle subit une déformation en tension suffisante.

Pour ces raisons de clarté, on décrit tout d'abord une photodiode planaire comportant une portion de détection présentant une contrainte mécanique en tension. De préférence, la portion de détection est réalisée en un matériau semiconducteur cristallin dont la structure de bandes d'énergie est rendue directe par la contrainte mécanique en tension.

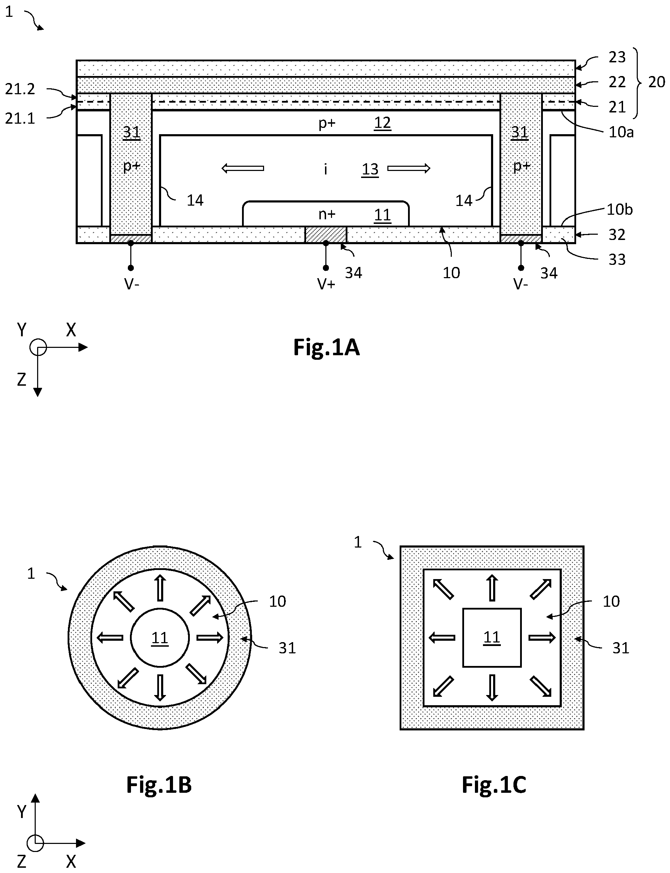

La figure 1A est une vue partielle et schématique, en coupe transversale, d'une photodiode 1 planaire appartenant à une matrice de photodiodes 1. Dans cet exemple, les photodiodes 1 sont réalisées ici à base de germanium. Elles sont polarisées en inverse à partir d'une face 10b et sont optiquement isolées les unes des autres par des tranchées périphériques 30 remplies d'un matériau semiconducteur cristallin dopé, ici à base de silicium dopé p+.

On définit ici et pour la suite de la description un repère direct tridimensionnel (X,Y,Z), où les axes X et Y forment un plan parallèle au plan principal des photodiodes 1, et où l'axe Z est orienté suivant l'épaisseur de la portion de détection 10 de la photodiode 1, à partir de la première face 10a en direction de la deuxième face 10b.

La photodiode 1 comporte une portion de détection 10 s'étendant suivant l'axe Z entre une première et une deuxième faces 10a, 10b parallèles entre elles et opposées l'une à l'autre. Les première et deuxième faces 10a, 10b sont communes à chaque photodiode 1 de la matrice. Elles peuvent être sensiblement planes, de sorte que la portion de détection 10 présente une épaisseur suivant l'axe Z sensiblement constante, par exemple comprise entre quelques centaines de nanomètres et quelques microns, par exemple comprise entre 1µm et 5µm environ. L'épaisseur est choisie de manière à obtenir une bonne absorption dans la gamme de longueurs d'onde du rayonnement lumineux à détecter. La portion de détection 10 est délimitée dans le plan XY par une bordure latérale 10c qui relie les deux faces 10a, 10b l'une à l'autre. La bordure latérale 10c peut s'étendre de manière sensiblement parallèle à l'axe Z. La portion de détection 10 présente une dimension transversale dans le plan XY pouvant être comprise entre quelques centaines de nanomètres et une centaine de microns, par exemple comprise entre 1µm et 20µm environ.

La portion de détection 10 est réalisée à base d'un premier matériau semiconducteur cristallin, de préférence monocristallin, ici à base de germanium. Par « à base de », on entend que la portion de détection 10 est réalisée en le premier matériau semiconducteur cristallin ou en un composé formé d'au moins le premier matériau semiconducteur cristallin. Le premier matériau semiconducteur cristallin est avantageusement du germanium, de sorte que les photodiodes 1 sont réalisées en germanium Ge, en silicium germanium SiGe, en germanium étain GeSn, et en silicium germanium étain SiGeSn. Dans cet exemple, la portion de détection 10 est réalisée en germanium.

La portion de détection 10 est ainsi formée d'une première région 11 dopée selon un premier type de conductivité, ici de type n+, qui affleure la face 10b et forme un caisson dopé n+, et une deuxième région 12 dopée selon un deuxième type de conductivité opposé au premier type, ici de type p+, qui affleure la face 10a. Par affleurer, on entend « arriver au niveau de », ou « s'étendre à partir de ». Une région intermédiaire 13 intrinsèque (dans le cas d'une jonction PIN), ou dopée selon le deuxième type de conductivité (dans le cas d'une jonction PN), est située entre et au contact des deux régions dopées 11, 12, et entoure la première région 11 dopée n+ dans le plan XY. Dans cet exemple, la jonction semiconductrice est de type PIN, la première région 11 étant dopée de type n+, la deuxième région 12 dopée de type p+, et la région intermédiaire 13 est intrinsèque (non intentionnellement dopée).

La première région 11 dopée n+ s'étend ici à partir de la face 10b et est entourée par la région intermédiaire 13 dans le plan XY. Elle est distante de la bordure latérale 10c de la portion de détection 10 dans le plan XY. Elle forme ainsi un caisson dopé n+ qui affleure la face 10b et est espacée d'une distance non nulle vis-à-vis de la bordure latérale 10c ainsi que de la face 10a. Elle peut présenter un dopage pouvant être compris entre 5×10¹⁸et 3×10²⁰ at/cm³ environ.

La deuxième région 12 dopée ici p+ s'étend dans le plan XY en affleurant la face 10a, ici à partir de la bordure latérale 10c. Elle s'étend donc suivant l'axe Z à partir de la face 10a. Elle peut présenter une épaisseur sensiblement homogène suivant l'axe Z et ainsi affleurer uniquement une zone inférieure de la bordure latérale 10c. En variante, comme illustré sur la fig.1A, la deuxième région 12 dopée p+ peut présenter une région latérale 14 dopée p+ qui affleure continûment la bordure latérale 10c suivant l'axe Z et s'étend sur toute la périphérie de la portion de détection 10. La deuxième région 12 dopée p+ peut présenter un dopage pouvant être compris entre 10¹⁸ et 10²⁰ at/cm³ environ.

La région intermédiaire 13 est située entre les deux régions 11, 12 dopées n+ et p+. Elle entoure donc la première région 11 dopée n+ dans le plan XY et affleure ici localement la face 10b. Elle est ici intrinsèque de manière à former une jonction PIN mais peut être dopée selon le deuxième type de conductivité, par exemple de type p, pour former une jonction PN.

La photodiode 1 comporte une couche antireflet 20, s'étendant sur et au contact de la portion de détection 10, ici au contact de la face 10a. Elle s'étend également en regard de la portion périphérique 31 (décrite en détail plus loin), laquelle entoure dans le plan XY la portion de détection 10 et est réalisée en un deuxième matériau semiconducteur cristallin dont le coefficient de dilatation thermique est inférieur à celui du premier matériau semiconducteur cristallin de la portion de détection 10. La couche antireflet 20 est adaptée à limiter la réflexion du rayonnement lumineux incident par la portion de détection 10, améliorant ainsi le taux d'absorption associé à la photodiode 1. Elle forme une face de réception du rayonnement lumineux destiné à être détecté. Elle est formée d'un empilement de plusieurs sous-couches 21, 22, 23 parallèles entre elles. La couche antireflet 20 comporte en particulier une sous-couche 22 dite de germination, située dans cet exemple entre une première sous-couche 21 située au contact de la face 10a de la portion de détection 10 et une troisième sous-couche 23 opposée.

La sous-couche de germination 22 est réalisée en le deuxième matériau semiconducteur cristallin. Dans cet exemple, le deuxième matériau semiconducteur cristallin est du silicium dont le coefficient de dilatation thermique est égal à 2.6×10⁻⁶ K¹, et le premier matériau semiconducteur cristallin est du germanium dont le coefficient de dilatation thermique est égal à 5.9×10⁻⁶ K⁻¹. Le silicium de la sous-couche de germination 22 est de préférence monocristallin et intrinsèque, alors que le silicium de la portion périphérique 31 est fortement dopé selon le deuxième type de conductivité, ici de type p+. La portion périphérique 31 est en contact avec la sous-couche de germination 22. Par ailleurs, dans le cas d'une matrice de photodiodes 1, la sous-couche de germination 22 s'étend continûment en regard des différentes portions de détection 10 et des portions périphériques 31 correspondantes.

La première sous-couche 21 est réalisée en un matériau électriquement isolant, par exemple en un matériau diélectrique. Elle est formée ici d'un empilement de deux sous-couches dites de collage 21.1, 21.2, réalisées par exemple en un oxyde de silicium tel que de l'orthosilicate de tétraéthyle (TEOS), lesquelles ont été utilisées lors du procédé de fabrication pour assurer le collage de type oxyde-oxyde d'un substrat SOI et d'un substrat GeOI, comme décrit en détail plus loin. La première sous-couche 21 est disposée entre et au contact de la portion de détection 10 et de la sous-couche de germination 22. Elle est par ailleurs traversée suivant l'axe Z par la portion périphérique 31. Par ailleurs, dans le cas d'une matrice de photodiodes 1, la première sous-couche 21 s'étend continûment en regard des différentes portions de détection 10 et des portions périphériques 31 correspondantes.

La troisième sous-couche 23 est réalisée en un matériau électriquement isolant, par exemple en un matériau diélectrique, et ici en un oxyde de silicium. La troisième sous-couche 23 est disposée au contact de la sous-couche de germination 22. Elle est réalisée en un matériau présentant un indice de réfraction inférieur à celui de la sous-couche de germination 22 (ici en silicium) et à celui de la portion de détection 10 (ici en germanium).

Les différentes sous-couches 21, 22, 23 sont adaptées en termes d'épaisseur et d'indice de réfraction pour optimiser la transmission du rayonnement lumineux incident à l'intérieur de la portion de détection 10. A titre d'exemple, dans le cas d'une longueur d'onde λ du rayonnement lumineux à détecter égale à 1550nm environ, la première sous-couche 21 peut être en TEOS d'indice de réfraction n₁ égal à 1.47 et d'épaisseur égale à 263nm environ, la sous-couche de germination 22 peut être en silicium mono cristallin intrinsèque d'indice de réfraction n₂ égal à 3.42 et d'épaisseur égale à 226nm environ, et la troisième sous-couche 23 peut être en SiO₂ d'indice de réfraction n₃ égal à 1.47 et d'épaisseur de 263nm environ. Dans ce cas, le coefficient de réflexion du rayonnement lumineux à détecter au niveau de la face 10a de la portion de détection 10 est de 11% environ, alors qu'il est de 48% environ en l'absence d'une telle couche antireflet 20.

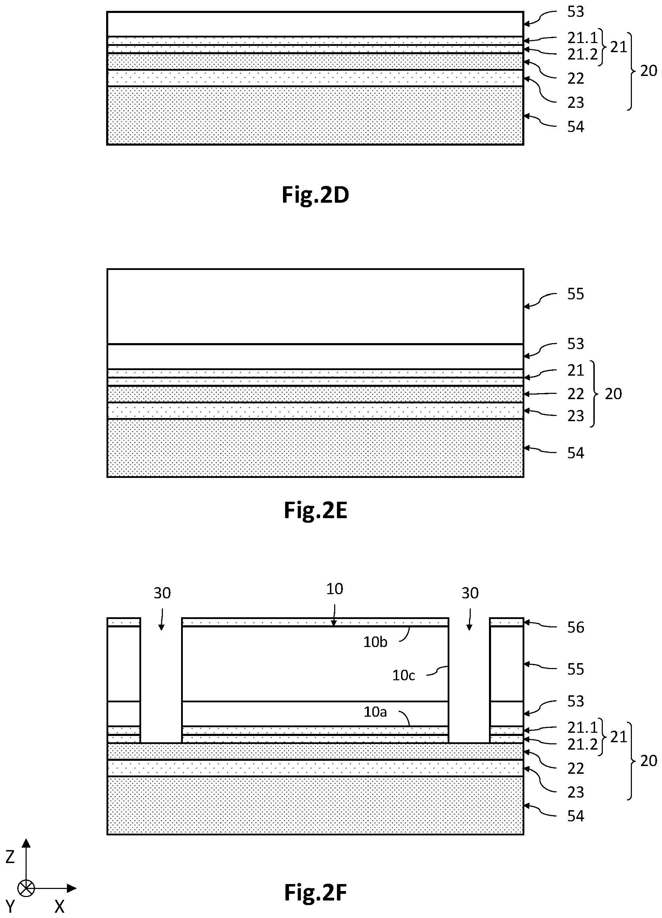

La portion de détection 10 de la photodiode 1 est ici délimitée latéralement, dans le plan XY, par une tranchée périphérique (cf. fig.2F), qui s'étend autour de la portion de détection 10 de préférence continue. Elle est remplie en le deuxième matériau semiconducteur cristallin, lequel est dopé selon le deuxième type de conductivité et forme ici une portion périphérique 31 dopée p+. La portion périphérique 31 s'étend ici sur toute l'épaisseur de la portion de détection 10 et traverse la première sous-couche 21 de la couche antireflet 20, pour déboucher sur la sous-couche de germination 22. La portion périphérique 31 dopée p+ est alors en contact avec la sous-couche de germination 22, et avec la bordure latérale 10c de la portion de détection 10. Le deuxième matériau semiconducteur cristallin présente un coefficient de dilatation thermique inférieur à celui du premier matériau semiconducteur. Dans le cas d'une portion de détection 10 à base de germanium, la portion périphérique 31 et la sous-couche de germination 22 sont réalisées à base de silicium, et sont de préférence en silicium par exemple polycristallin, voire du SiGe ou une alternance Si/SiGe. La portion périphérique 31 présente une relation d'épitaxie avec la sous-couche de germination 22, dans la mesure où, comme décrit plus loin, la portion périphérique 31 a été réalisée par épitaxie à partir de la sous-couche de germination 22. Par relation d'épitaxie, on entend que la structure cristalline du silicium dopé p+ de la portion périphérique 31 présente un alignement de ses orientations cristallographiques dans au moins une direction dans le plan du matériau et de préférence dans au moins une direction orthogonale au plan du matériau, avec celles de la structure cristalline du silicium de germination.

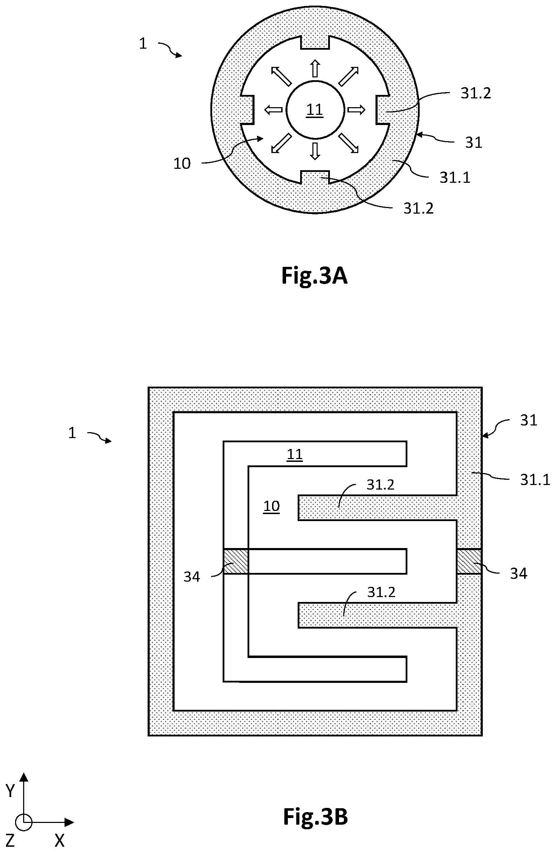

Comme l'illustrent les fig.1B et 1C, la portion périphérique 31 peut présenter diverses formes dans le plan XY, par exemple une forme ovale ou circulaire (fig.1B), voire une forme polygonale, par exemple carrée (fig.1C). D'autres formes sont possibles, comme illustré plus loin en référence aux fig.3A et 3B.

Une couche d'hybridation 32 recouvre la face 10b de la portion de détection 10. Elle est ici au contact de la région intermédiaire qui affleure ici la face 10b, et est au contact de la première région 11 dopée n+. Elle est réalisée en un matériau diélectrique, tel qu'un oxyde de silicium, un nitrure de silicium, ou un oxynitrure de silicium. D'autres matériaux diélectriques peuvent être utilisés, tels qu'un oxyde d'hafnium ou d'aluminium, voire un nitrure d'aluminium, entre autres. Elle présente une épaisseur par exemple comprise entre 50nm et 500nm. Des métallisations de contact 34 s'étendent au travers de la couche d'hybridation 32, et viennent au contact de la première région 11 dopée n+ et de la portion périphérique 31 dopée p+.

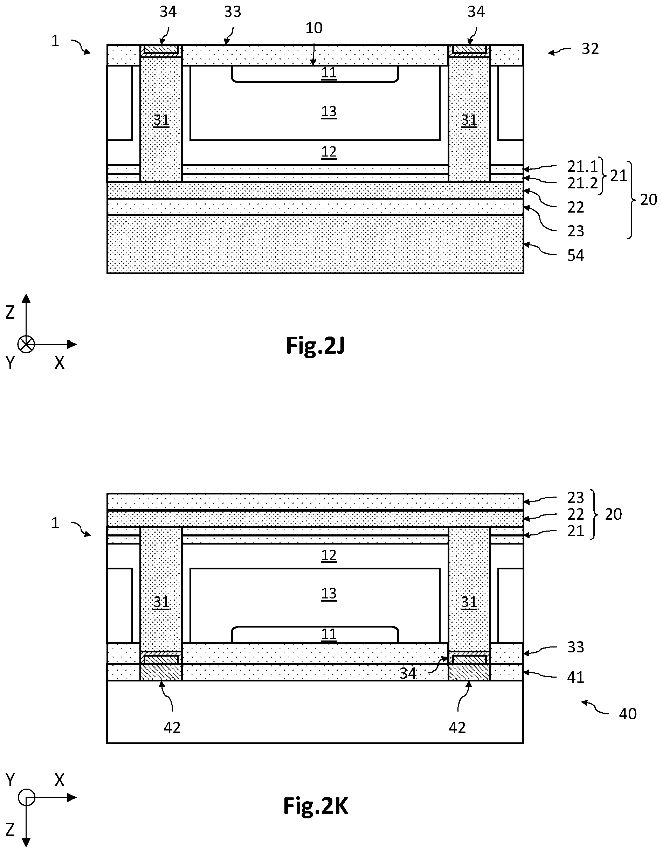

La matrice de photodiodes 1 est assemblée à une puce de commande (non représentée). L'hybridation de la matrice de photodiodes 1 à la puce de commande, c'est-à-dire l'assemblage mécanique et la connexion électrique, est effectuée par collage moléculaire hybride. La face de connexion de la puce de commande peut être revêtue d'une couche isolante, réalisée en un matériau diélectrique, traversée par des métallisations de contact. Le collage moléculaire hybride est assuré par le contact mécanique entre les métallisations de contact et par le contact mécanique entre la couche de passivation et la couche isolante (cf. fig.2K).

La portion de détection 10 présente une contrainte mécanique en tension dans le plan XY susceptible de rendre directe la structure de bandes du premier matériau semiconducteur cristallin, ici du germanium. Cette contrainte en tension provient du fait que le matériau cristallin (ici le silicium) de la portion périphérique 31 présente un coefficient de dilatation thermique inférieur à celui du matériau cristallin (ici le germanium) de la portion de détection 10, et que la portion périphérique 31 est réalisée par épitaxie à partir de la sous-couche de germination 22. Ainsi, lors du refroidissement après l'épitaxie de la portion périphérique 31, le germanium cristallin de la portion de détection 10 reste contraint en tension par le silicium cristallin de la portion périphérique 31. De plus, le fait que le silicium cristallin de la portion périphérique 31 soit épitaxié à partir de la sous-couche de germination 22 permet de maintenir en tension la portion de détection 10, empêchant celle-ci de relaxer dans le plan XY.

Par ailleurs, le fait que le matériau cristallin (ici le silicium) de la portion périphérique 31 soit identique à celui de la sous-couche de germination 22 (au dopage près) permet d'obtenir un matériau épitaxié de qualité cristalline élevée (peu de défauts cristallins de type dislocations de désaccord de maille), ce qui contribue à améliorer l'intensité et l'homogénéité spatiale de la contrainte en tension. En effet, les dislocations dans la portion périphérique 31 peuvent conduire à diminuer l'intensité locale et donc l'homogénéité spatiale de la contrainte en tension dans la portion de détection 10. Par ailleurs, de préférence, la portion périphérique 31 s'étend en saillie vis-à-vis des deux faces 10a, 10b de la portion de détection 10, ce qui permet d'améliorer encore l'homogénéité spatiale de la contrainte en tension dans la portion de détection 10.

On peut ainsi obtenir une photodiode 1 avec une longueur d'onde de coupure de détection supérieure à 1550nm, voire à 1620nm, donc opérationnelle dans le domaine des télécommunications optiques, avec une sensibilité élevée. La couche antireflet 20 présente donc une double fonction, à savoir une fonction optique de réduction de la réflexion du rayonnement lumineux incident à l'interface de la portion de détection 10, et une fonction cristallographique et mécanique permettant la germination du matériau cristallin de la portion périphérique 31 et l'accroche mécanique de la portion périphérique 31 sur la sous-couche de germination 22, permettant ainsi de maintenir en tension la portion de détection 10.

De plus, la photodiode 1 présente un faible encombrement, dans la mesure où la portion périphérique 31 s'étend de manière sensiblement coplanaire avec la portion de détection 10. Un tel agencement de la portion périphérique 31 par rapport à la portion de détection 10 de chacune des photodiodes permet d'obtenir une densité spatiale de photodiodes 1 élevée, et donc une haute résolution spatiale dans le cas d'une matrice de photodiodes 1.

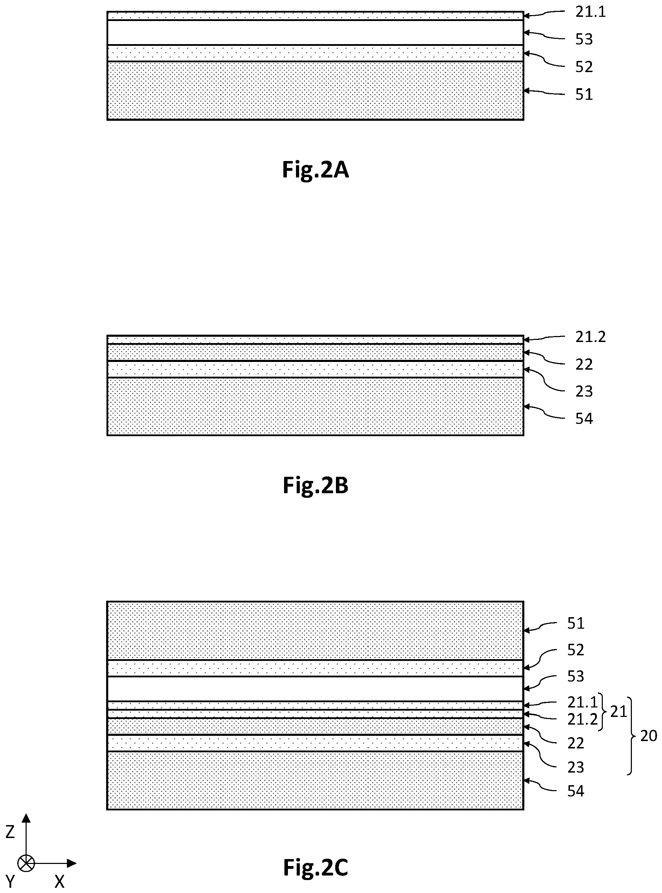

Un exemple de procédé de réalisation de la matrice de photodiodes planaires contraintes en tension telle qu'illustrée sur la figure 1A est maintenant décrit en référence aux figures 2A à 2K.

Lors d'une première étape (fig.2A), on réalise un substrat GeOI (pour *Germanium On Insulator,* en anglais). On réalise ainsi une première couche semiconductrice 53 de germanium monocristallin, solidarisée à une couche support 51, ici en silicium, par l'intermédiaire d'une couche isolante 52, ici en un oxyde de silicium. Cet empilement est de préférence réalisé au moyen du procédé décrit dans la publication de Reboud et al. intitulée Structural and optical properties of 200mm germanium-on-insulator (GeOI) substrates for silicon photonics applications, Proc. SPIE 9367, Silicon Photonics X, 936714 (February 27, 2015). Un tel procédé présente l'avantage de réaliser une première couche semiconductrice 53 de germanium présentant une absence quasi-totale de défauts structuraux tels que les dislocations. Le germanium est ici dopé de type p+ au moyen de gallium ou de bore. La première couche semiconductrice 53 peut présenter une épaisseur comprise entre 20nm et 600nm environ, par exemple égale à 300nm environ. La couche isolante 52 (BOX, pour *Buried Oxide,* en anglais) peut présenter une épaisseur comprise entre 50nm et 1 µm. La première couche semiconductrice 53 est recouverte d'une couche diélectrique 21.1 dite de collage, réalisée en un oxyde, par exemple en TEOS. Comme décrit plus loin, cette couche diélectrique de collage 21.1 permet d'assurer le collage du substrat GeOI avec un substat SOI, et participe à former la première sous-couche 21 de la couche antireflet 20.

Lors d'une autre étape (fig.2B), on réalise un substrat SOI (pour *Silicon On Insulator,* en anglais). On réalise ainsi une couche 22 en le deuxième matériau semiconducteur cristallin, ici en silicium cristallin et de préférence monocristallin, qui est destinée à former la sous-couche de germination de la couche reflet 20. Elle est assemblée à une couche support 54, ici en silicium, par une couche diélectrique 23, ici une couche BOX en oxyde de silicium, qui forme la troisième sous-couche de la couche antireflet 20. On réalise une couche diélectrique 21.2 dite de collage, réalisée en un oxyde, par exemple du TEOS, recouvrant la couche de silicium 22. Cette couche diélectrique de collage 21.2 permet d'assurer le collage du substrat SOI avec le substrat GeOI, et participe à former la première sous-couche 21 de la couche antireflet 20.

Lors d'une étape suivante (fig.2C), on assemblage le substrat GeOI sur le substrat SOI par collage oxyde-oxyde en mettant au contact les faces libres des deux couches diélectriques de collage 21.1, 21.2. Le collage peut être réalisé à température ambiante, et un polissage mécano-chimique peut être effectué sur la face libre de la couche support 51 de silicium du GeOI pour obtenir une face plane. Un recuit de consolidation peut être effectué pour renforcer l'adhésion entre les deux couches diélectriques de collage 21.1, 21.2, à une température par exemple comprise entre 200°C et 600°C. La première couche semiconductrice 53 en germanium dopé p+ repose ainsi sur un empilement de plusieurs couches formant la couche antireflet 20, à savoir de la première sous-couche 21 formée par les deux couches diélectriques de collage 21.1, 21.2, de la couche de silicium formant la sous-couche de germination 22, et de la troisième sous-couche 23.

Lors d'une étape suivante (fig.2D), on rend libre une face opposée à la couche antireflet 20 de la première couche semiconductrice 53 de germanium dopée p+. Pour cela, on effectue le retrait de la couche support 51 du substrat GeOI, par exemple par meulage (*grinding,* en anglais) avec arrêt pour garder une partie restante de silicium de 10 à 20µm environ d'épaisseur, suivi du retrait de la partie restante par gravure physique (plasma par ex.) ou par gravure humide. La face de la couche isolante 52 du substrat GeOI est alors rendue libre. La couche isolante 52 est ensuite retirée, par exemple par gravure physique (plasma par ex.) ou par gravure humide, rendant ainsi libre la face de la première couche semiconductrice 53 en germanium dopée p+ du substrat GeOI.

Lors d'une étape suivante (fig.2E), on réalise une deuxième couche semiconductrice 55 en le premier matériau semiconducteur cristallin, ici en germanium. Ainsi, après un nettoyage de la face libre de la première couche semiconductrice 53 pour désoxyder la surface, on effectue la croissance par épitaxie de la deuxième couche semiconductrice 55, ici en germanium intrinsèque, à partir de la face libre de la première couche semiconductrice 53 en germanium dopée p+. La température d'épitaxie peut être comprise entre 400°C et 850°C, et de préférence comprise entre 700°C et 850°C de manière à augmenter la contrainte en tension dans la portion de détection au terme du procédé de fabrication. En effet, le fait de faire l'épitaxie à haute température peut permettre de s'affranchir des différents contaminants et d'augmenter la différence des coefficients de dilatation thermique (CTE) entre la zone 31 et la zone 10, ce qui peut augmenter les contraintes en tension dans la portion de détection après retour à la température ambiante. La deuxième couche semiconductrice 55 présente une épaisseur qui dépend de la gamme de longueur d'onde du rayonnement lumineux à détecter. Dans le cas d'une photodiode SWIR, elle peut présenter une épaisseur comprise entre 0.5µm et 3µm, et par exemple égale à 1.5µm environ. Elle est destinée à former la zone d'absorption lumineuse des photodiodes. Elle présente un taux très faible de défauts structuraux du type dislocations, dans la mesure où il est épitaxié à partir du germanium de la première couche semiconductrice 53, ce qui permet d'améliorer l'absorption de la portion de détection de la photodiode. De plus, des recuits peuvent être effectués pour diminuer le taux de dislocations.

Lors d'une étape suivante (fig.2F), on réalise les tranchées périphériques 30. Pour cela, une couche de protection 56 en un matériau diélectrique est tout d'abord déposée sur la face libre de la deuxième couche semiconductrice 55 en germanium intrinsèque. Cette couche de protection 56 peut être réalisée en un oxyde de silicium, et peut présenter une épaisseur comprise entre 50nm et 200nm environ. Ensuite, par photolithographie et gravure, on réalise les tranchées périphériques 30 de manière à définir des portions de détection 10. Celles-ci sont délimitées par les faces 10a, 10b et par la bordure latérale 10c. Chaque tranchée périphérique 30 s'étend dans le plan XY de préférence continûment pour définir une portion de détection 10 en germanium. Elle s'étend suivant l'axe Z au travers de la deuxième couche semiconductrice 55 en germanium intrinsèque, de la première couche semiconductrice 53 en germanium dopé p+, des deux couches diélectriques de collage 21.1, 21.2, pour déboucher sur la sous-couche de germination 22 en silicium intrinsèque. Elle peut s'étendre dans le plan XY de manière à former un cercle ou un carré, entre autres. Elle présente une largeur sensiblement homogène suivant l'axe Z, laquelle peut être comprise entre 0.5µm et 2µm.

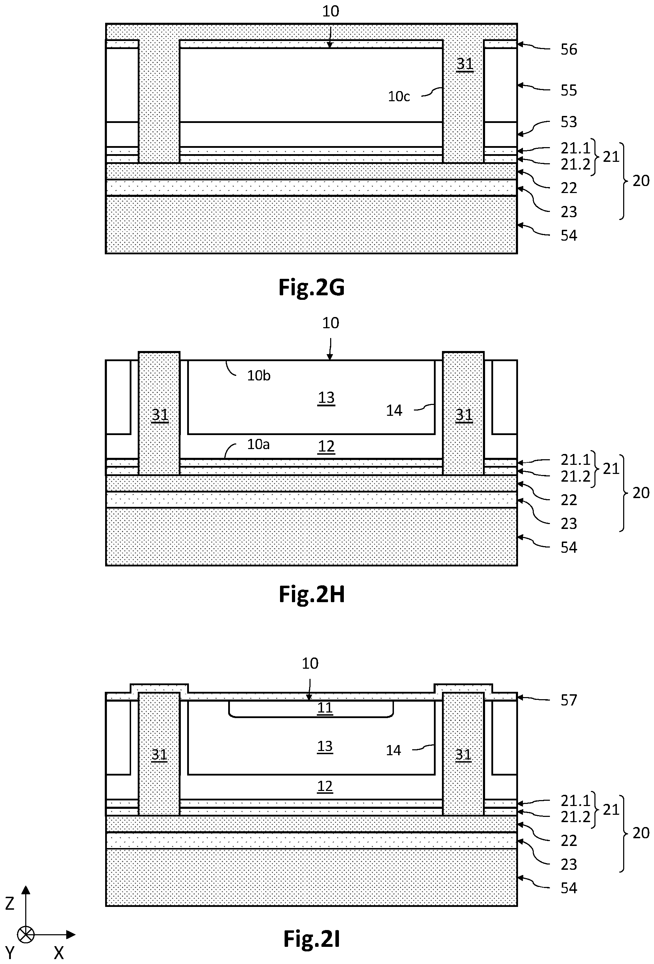

Lors d'une étape suivante (fig.2G), on réalise les portions périphériques 31 en silicium dopé p+. Pour cela, on effectue la croissance épitaxiale de silicium dopé p+ à partir de la surface libre de la sous-couche de germination 22. La température d'épitaxie est supérieure à la température ambiante, laquelle peut être égale à 25°C, et peut être comprise entre 500°C et 700°C environ, c'est-à-dire à 10% près, et de préférence comprise entre 600°C et 700°C environ, de manière à former, ou participer à former, la région latérale 14 à base de SiGe. Le silicium épitaxié croît à partir de la sous-couche de germination 22 et remplit les tranchées périphériques 30. Il est donc au contact de la bordure latérale 10c des portions de détection 10 en germanium. Il est déposé de manière à dépasser des tranchées périphériques 30 et recouvre ainsi la couche de protection 56.

A la suite de l'étape d'épitaxie, la température est ramenée à une température finale inférieure à la température d'épitaxie, par exemple à la température ambiante, par exemple à 25°C, ce qui provoque la mise en tension du germanium des portions de détection 10. En effet, lors de l'étape d'épitaxie du silicium dopé p+, le germanium des portions de détection 10 se dilate notamment dans le plan XY du fait de son coefficient de dilatation thermique égal à 5.9×10⁻⁶ K⁻¹. Le paramètre de maille du germanium dans le plan XY passe alors de la valeur relaxée de 5.658 Å à température ambiante à une valeur dilatée de 5.681 Å à 700°C environ. Le silicium épitaxié remplit les tranchées périphériques 30 et présente un paramètre de maille dilaté dans le plan XY, par exemple égal à 5.441 Å à 700°C environ (la valeur initiale étant égale à 5.431 Å à température ambiante) du fait de son coefficient de dilatation thermique égal à 2.6×10⁻⁶ K⁻¹. Lors de l'étape de refroidissement, du fait du couplage mécanique entre la portion périphérique 31 (i.e. le silicium épitaxié situé dans la tranchée périphérique 30) et le germanium de la portion de détection 10 correspondante, le germanium est contraint en fonction du coefficient de dilatation thermique du silicium et non plus en fonction de son propre coefficient de dilatation thermique. Dans la mesure où le coefficient de dilatation thermique du silicium est inférieur à celui du germanium, le germanium présente un paramètre de maille dans le plan XY égal à 5.671 Å à température ambiante, ce qui correspond à une dilatation de l'ordre de 0.22% environ par rapport à sa valeur relaxée de 5.658 Å. Aussi, le germanium de la portion de détection 10 est effectivement contraint en tension à l'issue de l'étape de refroidissement par le silicium de la portion périphérique 31. De plus, il reste contraint en tension par le fait que le silicium de la portion périphérique 31 est assemblé par une relation d'épitaxie au silicium de la sous-couche de germination 22. Celle-ci assure donc le maintien mécanique des différentes portions périphériques 31, et garde ainsi les portions de détection 10 contraintes en tension, dans la mesure où elle empêche celles-ci de relaxer dans le plan XY.

Lors d'une étape suivante (fig.2H), on effectue un retrait du silicium reposant sur la couche de protection 56, par exemple par un polissage mécano-chimique avec arrêt sur la couche de protection 56. Un recuit de diffusion peut être effectué, par exemple à une température comprise entre 700°C et 800°C, de manière à provoquer la diffusion des éléments dopants, ici le bore, à partir du silicium dopé p+ de la portion périphérique 31 dans le silicium intrinsèque de la portion de détection 10, formant ainsi une région latérale 14 dopée p+. De manière simultanée, une zone latérale à ouverture de gap est formée par interdiffusion entre le germanium de la portion de détection 10 et le silicium de la portion périphérique 31. On effectue ensuite le retrait de la couche de protection 56. La portion périphérique 31 est alors en saillie vis-à-vis de la portion de détection 10 suivant l'axe Z, tant au niveau de la face 10a que de la face 10b, ici sur une hauteur de l'ordre de 100nm environ pour ce qui concerne la face 10b. Ceci contribue à améliorer l'homogénéité spatiale de la contrainte en tension au sein de la portion de détection 10.

Lors d'une étape suivante (fig.2I), on réalise les premières portions 11 dopées n+. Pour cela, on dépose une couche de protection 57 en un matériau diélectrique, par exemple en un oxyde de silicium, d'une épaisseur par exemple comprise entre 10nm et 30nm environ. Ensuite, par photolithographie, on définit dans une résine photosensible (non représentée) des ouvertures correspondant à des zones d'implantation définissant les premières régions 11 dopées n+. On effectue ensuite une implantation ionique d'un dopant tel que le phosphore ou de l'arsenic, au travers des ouvertures. Les premières régions 11 sont de préférence surdopées n+, et peuvent ainsi présenter un niveau de dopage compris entre 5.10¹⁸ et 3.10²⁰ at/cm³ environ. Les premières régions 11 dopées n+ forment ainsi des caissons dopés n+ délimités dans le plan XY et suivant l'axe Z par la région intermédiaire 13 en germanium intrinsèque. Après retrait de la résine photosensible, un recuit de diffusion des dopants peut être effectué, par exemple à une température comprise entre 400°C et 750°C pendant une durée de quelques secondes à quelques dizaines de minutes, par exemple à 600°C pendant 10s.

Lors d'une étape suivante (fig.2J), on réalise une couche 32 permettant l'hybridation de la matrice de photodiodes à une puce de commande. Pour cela, on retire entièrement la couche de protection 57, par exemple par gravure de type plasma ou par gravure humide, et on dépose une couche de passivation 33 de manière à recouvrir les portions de détection 10 ainsi que les portions périphériques 31. La couche de passivation 33 est réalisée en un matériau diélectrique, par exemple un oxyde, nitrure ou oxynitrure de silicium, un oxyde ou nitrure d'aluminium, un oxyde d'hafnium, entre autres. La couche de passivation peut présenter une épaisseur par exemple comprise entre 10nm et 500nm.

On réalise ensuite des ouvertures par gravure localisée de la couche de passivation 33, qui débouchent sur les portions périphériques 31 et sur les premières régions 11 dopées n+. Des métallisations de contact 34 sont ensuite réalisées dans les ouvertures, qui peuvent être formées d'une gaine en Ti/TiN et d'un coeur en tungstène W ou en cuivre. Pour cela, une couche mince métallique est déposée dans les ouvertures de manière conforme, par exemple formée d'une sous-couche de titane Ti d'une épaisseur de 5nm environ puis d'une sous-couche de nitrure de titane TiN d'une épaisseur de 10nm environ. Un recuit est effectué de manière à améliorer le contact électrique entre le titane et le germanium d'une part, et entre le titane et le silicium d'autre part. Lors de ce recuit, le germanium dopé n+ des premières régions 11 diffuse de sorte que celle-ci occupe un volume plus important dans la portion de détection 10. Une couche métallique, par exemple réalisée en tungstène W ou en cuivre Cu, est ensuite déposée de manière à remplir les ouvertures. Une étape de polissage mécano-chimique est ensuite effectuée, avec arrêt sur la couche de passivation 33. On obtient ainsi des métallisations de contact 34 formées d'une gaine en Ti/TiN et d'un coeur en W ou en Cu, situées dans la couche de passivation 33 et traversant cette dernière.

Lors d'une étape suivante (fig.2K), on effectue l'hybridation de la matrice de photodiodes 1 ainsi obtenues sur une puce de commande 40. La face de connexion de la puce de commande peut ainsi être revêtue d'une couche isolante 41, réalisée en un matériau diélectrique, traversée par des métallisations de contact 42. La matrice de photodiodes 1 et la puce de commande 40 sont ainsi assemblées par adhésion moléculaire hybride, par contact des faces formées des métallisations de contact 34,42 et des couches isolantes 33, 41. Un recuit de collage peut être effectué de manière à augmenter l'énergie de collage surfacique entre les deux faces en contact.

On réalise ensuite la suppression de la couche support 54 du substrat SOI, par exemple par meulage (*grinding*)*,* de manière à exposer la troisième sous-couche 23 de la couche antireflet 20. Celle-ci forme ainsi la face de réception du rayonnement lumineux à détecter.

Le procédé de fabrication permet ainsi d'obtenir une ou plusieurs photodiodes 1 planaires et contraintes en tension. Ainsi, plus précisément, les portions de détection 10 sont mises en tension à la suite de l'étape d'épitaxie des portions périphériques 31, du fait que celles-ci sont réalisées en un matériau dont le coefficient de dilatation thermique est inférieur à celui du matériau des portions de détection.

De plus, le fait que les portions périphériques 31 soient obtenues par épitaxie à partir de la sous-couche de germination 22 qui s'étend continûment sous les portions de détection 10 permet d'assurer le maintien en tension des portions de détection 10, empêchant en effet celles-ci de relaxer dans le plan XY. La couche antireflet 20 présente alors la double fonction de permettre de réduire la réflexion du rayonnement lumineux à détecter à l'interface du germanium, et d'assurer le maintien mécanique en tension des portions de détection 10 via les portions périphériques 31.

Par ailleurs, le procédé de fabrication permet d'obtenir des portions de détection 10 réalisées en un germanium de qualité cristalline élevée, par l'utilisation d'un substrat GeOI. Par ailleurs, la sous-couche de germination 22 est réalisée en silicium de qualité cristalline élevée par l'utilisation d'un substrat SOI. Le procédé de fabrication utilise ainsi des substrats GeOI et SOI assemblés l'un à l'autre. Les couches diélectriques de collage 21.1, 21.2 forment l'une des sous-couches de bas indice de réfraction de la couche antireflet 20.

Des modes de réalisation particuliers viennent d'être décrits. Différentes variantes et modifications apparaîtront à l'homme du métier.

A ce titre, les figures 3A et 3B sont des vues de dessus, schématiques et partielles, d'une photodiode planaire 1 contrainte en tension selon des variantes du mode de réalisation illustré sur la fig. 1A.

Dans l'exemple de la fig.3A, la portion périphérique 31 s'étend de manière circulaire autour de la portion de détection 10 et de sa première région 11 dopée n+. Elle présente ici, dans le plan XY, une partie principale 31.1 sensiblement circulaire, et des parties en saillie 31.2, ou protubérances, qui s'étendent à partir de la partie principale circulaire 31.1 en direction de la première région 11 dopée n+. Ces parties en saillie 31.2 présentent ici une forme rectangulaire dans le plan XY mais d'autres formes sont possibles. Dans cet exemple, elles sont disposées deux à deux de manière symétrique par rapport au centre de la première région 11 dopée n+. Quoi qu'il en soit, ces parties en saillie 31.2 de la portion périphérique 31 permettent de répartir et d'optimiser la contrainte en tension au sein de la portion de détection 10.

Dans l'exemple de la fig.3B, la portion périphérique 31 s'étend de manière rectangulaire autour de la portion de détection 10. Elle comporte une partie principale 31.1 sensiblement rectangulaire, et des parties en saillie 31.2 qui s'étendent à partir de la partie principale 31.1 en direction de la première région 11 dopée n+. Ces parties en saillie 31.2 s'étendent ici de manière rectiligne. Dans cet exemple, la première région dopée n+ est « interdigitée », c'est-à-dire qu'elle est formée de différentes parties reliées les unes aux autres, qui s'étendent continûment entre les parties en saillie 31.2 d'une part, et entre les parties en saillie 31.2 et la partie principale 31.1 d'autre part. Une ou plusieurs métallisations de contact 34 peuvent être disposées localement au contact de la première région 11 dopée n+ et la portion périphérique 31. Dans cet exemple, la photodiode 1 peut présenter une dimension dans le plan XY comprise entre 10µm et 100µm environ, et la portion périphérique 31 peut présenter une largeur dans le plan XY comprise entre 1 µm à 2µm environ. D'autres formes et agencements de la portion périphérique 31 et de la première région 11 dopée n+ sont bien sûr possibles.

## Revendications

1. Procédé de fabrication d'au moins une photodiode (1) planaire, comportant les étapes suivantes :
o réalisation d'un empilement formé :
• d'au moins une couche semiconductrice (53, 55) réalisée à base d'un premier matériau semiconducteur cristallin ; et
• d'une couche antireflet (20), s'étendant au contact d'une première face (10a) de la couche semiconductrice (53, 55), et formée de plusieurs sous-couches (21, 22, 23) parallèles entre elles, dont une sous-couche (22) dite de germination réalisée à base d'un deuxième matériau semiconducteur cristallin présentant un coefficient de dilatation thermique inférieur à celui du premier matériau semiconducteur cristallin ;
o réalisation d'au moins une tranchée périphérique (30), s'étendant au travers de la couche semiconductrice (53, 55) à partir d'une deuxième face (10b) de celle-ci opposée à la première face (10a) et débouchant sur la sous-couche de germination (22), délimitant une portion dite de détection (10) de la couche semiconductrice (53, 55) ;
o réalisation d'une portion périphérique (31), réalisée en le deuxième matériau semiconducteur cristallin, par épitaxie à partir de la sous-couche de germination (22) à une température dite d'épitaxie supérieure à la température ambiante, et remplissant entièrement la tranchée périphérique (30) et étant ainsi au contact de la portion de détection (10) ;
o diminution de la température à une valeur inférieure à la température d'épitaxie, la portion de détection (10) étant alors contrainte en tension par la portion périphérique (31).

2. Procédé de fabrication selon la revendication 1, comportant les étapes suivantes :
o réalisation d'un premier substrat comportant une première couche semiconductrice (53) en le premier matériau semiconducteur cristallin, revêtue d'une première couche diélectrique de collage (21.1) ;
o réalisation d'un deuxième substrat comportant une couche en le deuxième matériau semiconducteur cristallin destinée à former la sous-couche de germination (22), revêtue d'une deuxième couche diélectrique de collage (21.2), et assemblée à une couche support (54) par une couche isolante (23) ;
o assemblage des deux substrats l'un à l'autre, par collage moléculaire des première et deuxième couches diélectriques de collage (21.1, 21.2), et ainsi obtention de la couche antireflet (20), les première et deuxième couches diélectriques de collage (21.1, 21.2) formant une première sous-couche (21) de la couche antireflet (20) et la couche isolante (23) formant une troisième sous-couche (23) de la couche antireflet (20).

3. Procédé de fabrication selon l'une quelconque des revendications 1 à 2, dans lequel la portion de détection (10) est réalisée à base de germanium, et la portion périphérique (31) et la sous-couche de germination (22) sont réalisées à base de silicium.

4. Procédé de fabrication selon la revendication 3, dans lequel la température d'épitaxie est comprise entre 500°C et 700°C.

5. Procédé de fabrication selon l'une quelconque des revendications 1 à 4, dans lequel plusieurs photodiodes (1) planaires sont réalisées, la sous-couche de germination (22) s'étendant continûment en regard de chaque photodiode (1), les portions périphériques (31) étant réalisées par épitaxie à partir de la sous-couche de germination (22).

6. Dispositif optoélectronique comportant au moins une photodiode (1) planaire, ladite photodiode comportant :
o une portion de détection (10), présentant une première face (10a) et une deuxième face (10b) parallèles entre elles, réalisée en un premier matériau semiconducteur cristallin, et contrainte en tension dans un plan parallèle auxdites faces (10a, 10b) ;
o une couche antireflet (20) s'étendant sur et au contact de la première face (10a) de la portion de détection (10), formée de plusieurs sous-couches (21, 22, 23) parallèles entre elles, dont une sous-couche (22) dite de germination réalisée à base d'un deuxième matériau semiconducteur cristallin présentant un coefficient de dilatation thermique inférieur à celui du premier matériau semiconducteur cristallin ;
o une portion périphérique (31), réalisée en le deuxième matériau semiconducteur cristallin, s'étendant autour et au contact de la portion de détection (10), et au contact avec relation d'épitaxie avec la sous-couche de germination (22).

7. Dispositif optoélectronique selon la revendication 6, dans lequel la portion périphérique (31) est en saillie vis-à-vis de la première face (10a) et vis-à-vis de la deuxième face (10b).

8. Dispositif optoélectronique selon la revendication 6 ou 7, dans lequel la portion de détection (10) comporte une première région (11) dopée selon un premier type de conductivité et affleurant la deuxième face (10b), et une deuxième région (12) dopée selon un deuxième type de conductivité opposé au premier type et affleurant la première face (10a) et étant au contact de la portion périphérique (31), la portion périphérique (31) étant dopée selon le deuxième type de conductivité.

9. Dispositif optoélectronique selon la revendication 8, dans lequel la portion de détection (10) comporte une région intermédiaire (13) intrinsèque ou dopée selon le deuxième type de conductivité, séparant la première région (11) vis-à-vis de la deuxième région (12).

10. Dispositif optoélectronique selon l'une quelconque des revendications 6 à 9, dans lequel la portion périphérique (31) entoure la portion de détection (10) continûment.

## Patentansprüche

1. Verfahren zur Herstellung mindestens einer planaren Fotodiode (1), das die folgenden Schritte umfasst:
o Ausführen eines Stapels, der gebildet ist:
• aus mindestens einer Halbleiterschicht (53, 55), die auf der Basis eines ersten kristallinen Halbleitermaterials ausgeführt ist; und
• aus einer Antireflexschicht (20), die sich in Kontakt mit einer ersten Seite (10a) der Halbleiterschicht (53, 55) erstreckt und aus mehreren zueinander parallelen Teilschichten (21, 22, 23) gebildet ist, darunter einer sogenannten Keimungsteilschicht (22), die auf der Basis eines zweiten kristallinen Halbleitermaterials ausgeführt ist, das einen geringeren Wärmedehnungskoeffizienten als das erste kristalline Halbleitermaterial aufweist;
o Ausführen mindestens eines umfänglichen Grabens (30), der sich durch die Halbleiterschicht (53, 55) hindurch von einer zweiten Seite (10b) von dieser aus, die zu der ersten Seite (10a) entgegengesetzt ist, erstreckt und der an der Keimungsteilschicht (22) mündet und einen sogenannten Detektionsabschnitt (10) der Halbleiterschicht (53, 55) begrenzt;
o Ausführen eines umfänglichen Abschnitts (31), der aus dem zweiten kristallinen Halbleitermaterial ausgeführt ist, durch Epitaxie von der Keimungsteilschicht (22) aus bei einer so genannten Epitaxietemperatur, die über der Umgebungstemperatur liegt, und der den umfänglichen Graben (30) vollständig füllt und somit in Kontakt mit dem Detektionsabschnitt (10) ist;
o Verringern der Temperatur auf einen Wert unter der Epitaxietemperatur, woraufhin der Detektionsabschnitt (10) durch den umfänglichen Abschnitt (31) auf Zug beansprucht wird.

2. Herstellungsverfahren nach Anspruch 1, das die folgenden Schritte umfasst:
o Ausführen eines ersten Substrats, das eine erste Halbleiterschicht (53) aus dem ersten kristallinen Halbleitermaterial umfasst, die mit einer ersten dielektrischen Klebeschicht (21.1) überzogen ist;
o Ausführen eines zweiten Substrats, das eine Schicht aus dem zweiten kristallinen Halbleitermaterial umfasst, die dazu bestimmt ist, die Keimungsteilschicht (22) zu bilden, die mit einer zweiten dielektrischen Klebeschicht (21.2) überzogen ist und die mit einer Trägerschicht (54) über eine isolierende Schicht (23) verbunden ist;
o Verbinden der beiden Substrate miteinander durch molekulares Kleben der ersten und zweiten dielektrischen Klebeschichten (21.1, 21.2) und somit Erhalten der Antireflexschicht (20), wobei die ersten und zweiten dielektrischen Klebeschichten (21.1, 21.2) eine erste Teilschicht (21) der Antireflexschicht (20) bilden und die isolierende Schicht (23) eine dritte Teilschicht (23) der Antireflexschicht (20) bildet.

3. Herstellungsverfahren nach einem der Ansprüche 1 bis 2, bei dem der Detektionsabschnitt (10) auf der Basis von Germanium ausgeführt ist und der umfängliche Abschnitt (31) und die Keimungsteilschicht (22) auf der Basis von Silicium ausgeführt sind.

4. Herstellungsverfahren nach Anspruch 3, bei dem die Epitaxietemperatur zwischen 500 °C und 700 °C beträgt.

5. Herstellungsverfahren nach einem der Ansprüche 1 bis 4, bei dem mehrere planare Fotodioden (1) ausgeführt werden, wobei sich die Keimungsteilschicht (22) durchgehend gegenüber jeder Fotodiode (1) erstreckt, wobei die umfänglichen Abschnitte (31) durch Epitaxie von der Keimungsteilschicht (22) aus ausgeführt sind.

6. Optoelektronische Vorrichtung, die mindestens eine planare Fotodiode (1) umfasst, wobei die Fotodiode umfasst:
o einen Detektionsabschnitt (10), der eine erste Seite (10a) und eine zweite Seite (10b) aufweist, die zueinander parallel sind, aus einem ersten kristallinen Halbleitermaterial ausgeführt ist und in einer parallel zu den Seiten (10a, 10b) verlaufenden Ebene auf Zug beansprucht wird;
o eine Antireflexschicht (20), die sich auf und in Kontakt mit der ersten Seite (10a) des Detektionsabschnitts (10) erstreckt und aus mehreren zueinander parallelen Teilschichten (21, 22, 23) gebildet ist, darunter einer sogenannten Keimungsteilschicht (22), die auf der Basis eines zweiten kristallinen Halbleitermaterials ausgeführt ist, das einen geringeren Wärmedehnungskoeffizienten als das erste kristalline Halbleitermaterial aufweist;
o einen umfänglichen Abschnitt (31), der aus dem zweiten kristallinen Halbleitermaterial ausgeführt ist und sich um den und in Kontakt mit dem Detektionsabschnitt (10) und in Kontakt mit epitaktischer Beziehung mit der Keimungsteilschicht (22) erstreckt.

7. Optoelektronische Vorrichtung nach Anspruch 6, wobei der umfängliche Abschnitt (31) in Bezug auf die erste Seite (10a) und in Bezug auf die zweite Seite (10b) übersteht.

8. Optoelektronische Vorrichtung nach Anspruch 6 oder 7, wobei der Detektionsabschnitt (10) einen ersten Bereich (11) umfasst, der gemäß einem ersten Leitfähigkeitstyp dotiert ist und bündig mit der zweiten Seite (10b) ist, und einen zweiten Bereich (12), der gemäß einem zweiten Leitfähigkeitstyp, der zum ersten Typ entgegengesetzt ist, dotiert ist und bündig mit der ersten Seite (10a) ist und in Kontakt mit dem umfänglichen Abschnitt (31) ist, wobei der umfängliche Abschnitt (31) gemäß dem zweiten Leitfähigkeitstyp dotiert ist.

9. Optoelektronische Vorrichtung nach Anspruch 8, wobei der Detektionsabschnitt (10) einen intrinsischen oder gemäß dem zweiten Leitfähigkeitstyp dotierten Zwischenbereich (13) umfasst, der den ersten Bereich (11) vom zweiten Bereich (12) trennt.

10. Optoelektronische Vorrichtung nach einem der Ansprüche 6 bis 9, bei welcher der umfängliche Abschnitt (31) den Detektionsabschnitt (10) durchgehend umgibt.

## Claims

1. Process for fabricating at least one planar photodiode (1), comprising the following steps:
o producing a stack formed:
• from at least one semiconductor layer (53, 55) made based on a first crystalline semiconductor; and
• from an antireflection layer (20) that extends in contact with a first face (10a) of the semiconductor layer (53, 55) and that is formed from a plurality of sublayers (21, 22, 23) that lie parallel to one another, including a sublayer (22) referred to as the seed sublayer, which is made based on a second crystalline semiconductor having a coefficient of thermal expansion lower than that of the first crystalline semiconductor;
o producing at least one peripheral trench (30) that extends through the semiconductor layer (53, 55) from a second face (10b) thereof opposite the first face (10a) and that opens onto the seed sublayer (22), bounding a section, referred to as the detecting section (10), of the semiconductor layer (53, 55);
o producing a peripheral section (31) made of the second crystalline semiconductor by epitaxy from the seed sublayer (22) at a temperature, referred to as the epitaxy temperature, higher than room temperature, entirely filling the peripheral trench (30) and thus being in contact with the detecting section (10);
o decreasing the temperature to a value lower than the epitaxy temperature, the detecting section (10) then being tensilely strained by the peripheral section (31).

2. Fabricating process according to Claim 1, comprising the following steps:
o producing a first substrate comprising a first semiconductor layer (53) made of the first crystalline semiconductor, this layer being coated with a first bonding dielectric layer (21.1);
o producing a second substrate comprising a layer made of the second crystalline semiconductor, this layer being intended to form the seed sublayer (22), coated with a second bonding dielectric layer (21.2) and joined to a carrier layer (54) by an insulating layer (23);
o joining the two substrates to each other by direct bonding of the first and second bonding dielectric layers (21.1, 21.2), and thus obtaining the antireflection layer (20), the first and second bonding dielectric layers (21.1, 21.2) forming a first sublayer (21) of the antireflection layer (20) and the insulating layer (23) forming a third sublayer (23) of the antireflection layer (20).

3. Fabricating process according to either of Claims 1 and 2, wherein the detecting section (10) is made based on germanium, and the peripheral section (31) and the seed sublayer (22) are made based on silicon.

4. Fabricating process according to Claim 3, wherein the epitaxy temperature is comprised between 500°C and 700°C.

5. Fabricating process according to any one of Claims 1 to 4, wherein a plurality of planar photodiodes (1) are produced, the seed sublayer (22) extending continuously facing each photodiode (1), the peripheral sections (31) being produced by epitaxy from the seed sublayer (22).

6. Optoelectronic device comprising at least one planar photodiode (1), said photodiode comprising:
o a detecting section (10) that has a first face (10a) and a second face (10b) parallel to each other, that is made of a first crystalline semiconductor and that is tensilely strained in a plane parallel to said faces (10a, 10b);
o an antireflection layer (20) that extends over and in contact with the first face (10a) of the detecting section (10), formed from a plurality of sublayers (21, 22, 23) that lie parallel to one another, including a sublayer (22) referred to as the seed sublayer, which is made based on a second crystalline semiconductor having a coefficient of thermal expansion lower than that of the first crystalline semiconductor;
o a peripheral section (31) made of the second crystalline semiconductor, extending around and in contact with the detecting section (10), and in contact, under an epitaxy relationship, with the seed sublayer (22).

7. Optoelectronic device according to Claim 6, wherein the peripheral section (31) protrudes with respect to the first face (10a) and with respect to the second face (10b).

8. Optoelectronic device according to Claim 6 or 7, wherein the detecting section (10) comprises a first region (11) that is doped a first conductivity type and that lies flush with the second face (10b), and a second region (12) that is doped a second conductivity type opposite the first type and that lies flush with the first face (10a) and that is in contact with the peripheral section (31), the peripheral section (31) being doped the second conductivity type.

9. Optoelectronic device according to Claim 8, wherein the detecting section (10) comprises an intermediate region (13) that is intrinsic or doped the second conductivity type, separating the first region (11) from the second region (12).

10. Optoelectronic device according to any one of Claims 6 to 9, wherein the peripheral section (31) encircles the detecting section (10) continuously.
